# EUROPEAN PATENT APPLICATION

(11) **EP 3 754 720 A1**
(43) Date of publication of application: **23.12.2020**
(21) Application number: 20166202.0
(22) Date of filing: 27.03.2020
(51) Int. Cl.: H01L 29/775, H01L 29/78, H01L 29/423, H01L 21/336, H01L 29/06, B82Y 10/00

(54) **RECESSED GATE OXIDE ON THE SIDEWALL OF GATE TRENCH**

(30) Priority: 19.06.2019 US 201916445700
(71) Applicant: Intel Corporation, Santa Clara, CA 95054 (US)
(72) Inventor: SUNG, Seung Hoon, Portland, Oregon 97229 (US); CHANG, Sou-Chi, Portland, Oregon 97229 (US); PENUMATCHA, Ashish Verma, Hillsboro, Oregon 97124 (US); HARATIPOUR, Nazila, Portland, Oregon 97124 (US); METZ, Matthew, Portland, Oregon 97229 (US); HARPER, Michael, Hillsboro, Oregon 97124 (US); KAVALIEROS, Jack, Portland, Oregon 97229 (US); AVCI, Uygar, Portland, Oregon 97225 (US); YOUNG, Ian, Portland, Oregon 97229 (US)
(74) Representative: HGF

(57) **Abstract**

Described is a transistor, preferably a FinFET or a nanowire FET, which includes: a source region (106); a drain region (108); and a gate region (105, 109) between the source and drain regions, wherein the gate region comprises: high-K dielectric material (105)m which may comprise a ferroelectric material, between spacers (107a, b) such that the high-K dielectric material is recessed; and metal electrode (109) on the recessed high-K dielectric material. The high-k dielectric material (105, 305, 325) may form a convex or a concave interface with the gate metal (109). The gate recessed gate dielectric allows for using thick gate dielectric even with much advanced process technology nodes (e.g., 7 nm and below).

## Description

### BACKGROUND

As device dimensions continue to shrink, gate oxide along vertical sides of a transistor gate make it challenging for forming a gate electrode. The background description provided here is for the purpose of generally presenting the context of the disclosure. Unless otherwise indicated here, the material described in this section is not prior art to the claims in this application and are not admitted to be prior art by inclusion in this section.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
**Figs. 1A-C** illustrates a finFET transistor with recessed gate oxide, in accordance with some embodiments.
**Fig. 2** illustrates a cross-sectional view of a nanowire transistor with recessed gate oxide, in accordance with some embodiments.
**Figs. 3A-B** illustrate various forms of recessed gate oxide, in accordance with some embodiments.
**Figs. 4A-D** illustrate cross-sections of a process of forming recessed gate oxide, in accordance with some embodiments.
**Fig.** 5 illustrates a smart device, a computer system, or a SoC (System-on-Chip) including a transistor with recessed gate oxide, in accordance with some embodiments of the disclosure.

### DETAILED DESCRIPTION

Some embodiments describe a transistor with recessed gate oxide without gate oxide on the sidewalls of the gate electrode or spacer. As gate dimensions get smaller for advanced process technology nodes (e.g., 7 nm and below), having thick gate oxide devices becomes a challenge because the thick gate oxides along the sidewall of the spacers take up enough space that little space is left for depositing metal electrode over the gate oxide. Thin metal oxide results in higher gate resistance. To reduce gate resistance while providing high-K thick gate oxides for transistors, in some embodiments, the gate oxide is recessed.

In some embodiments, a transistor is provided which comprises: a source region; a drain region; and a gate region between the source and drain regions, wherein the gate region comprises: high-K dielectric material between spacers such that the high-K dielectric material is recessed; and metal electrode on the recessed high-K dielectric material. In some embodiments, the high-K dielectric material includes one of: hafnium, silicon, oxygen, titanium, tantalum, lanthanum, aluminum, zirconium, barium, strontium, yttrium, lead, scandium, niobium, or zinc. In some embodiments, the high-K dielectric material is first dielectric material, and wherein the high-K dielectric material is on a second dielectric material different from the high-K dielectric material. In some embodiments, the second dielectric material comprises Si. In some embodiments, the first or second dielectric materials comprise ferroelectric material. In some embodiments, the recessed high-K dielectric material is U-shaped. In some embodiments, the metal electrode comprises one or more of: ruthenium, palladium, platinum, cobalt, nickel, or conductive metal oxides. In some embodiments, the metal electrode comprises one or more of: hafnium, zirconium, titanium, tantalum, aluminum, alloys of these metals, hafnium carbide, zirconium carbide, titanium carbide, tantalum carbide, or aluminum carbide. In some embodiments, the spacers include one or more of: Al, Ti, Hf, Si, or N. For example, spacers include one of: A1203, TiO2, HfO2, SiNx, or SiO2.

By having a recessed gate oxide, and process to make such, thicker gate oxides can be used while providing a low resistance metal electrode coupled to the gate oxide. As such, thicker gate oxide base transistors can be fabricated in smaller and advanced technology nodes (e.g., 7 nm and low). Other technical effects will be evident from the various embodiments and figures.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

The term "device" may generally refer to an apparatus according to the context of the usage of that term. For example, a device may refer to a stack of layers or structures, a single structure or layer, a connection of various structures having active and/or passive elements, etc. Generally, a device is a three-dimensional structure with a plane along the x-y direction and a height along the z direction of an x-y-z Cartesian coordinate system. The plane of the device may also be the plane of an apparatus which comprises the device.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected, or an indirect connection, through one or more passive or active intermediary devices.

The term "adjacent" here generally refers to a position of a thing being next to (e.g., immediately next to or close to with one or more things between them) or adjoining another thing (e.g., abutting it).

The term "circuit" or "module" may refer to one or more passive and/or active components that are arranged to cooperate with one another to provide a desired function.

The term "signal" may refer to at least one current signal, voltage signal, magnetic signal, or data/clock signal. The meaning of "a," "an," and "the," include plural references. The meaning of "in" includes "in" and "on."

The term "scaling" generally refers to converting a design (schematic and layout) from one process technology to another process technology and subsequently being reduced in layout area. In some cases, scaling to another process technology node also results in upsizing devices and their layout. The term "scaling" generally also refers to downsizing layout and devices within the same technology node. The term "scaling" may also refer to adjusting (e.g., slowing down or speeding up - i.e., scaling down, or scaling up respectively) of a signal frequency relative to another parameter; for example, power supply level.

The terms "substantially," "close," "approximately," "near," and "about," generally refer to being within +/- 10% of a target value. For example, unless otherwise specified in the explicit context of their use, the terms "substantially equal," "about equal" and "approximately equal" mean that there is no more than incidental variation between things so described. In the art, such variation is typically no more than +/-10% of a predetermined target value.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking, or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

The terms "left," "right," "front," "back," "top," "bottom," "over," "under," and the like in the description and in the claims, if any, are used for descriptive purposes and not necessarily for describing permanent relative positions. For example, the terms "over," "under," "front side," "back side," "top," "bottom," "over," "under," and "on" as used herein refer to a relative position of one component, structure, or material with respect to other referenced components, structures or materials within a device, where such physical relationships are noteworthy. These terms are employed herein for descriptive purposes only and predominantly within the context of a device z-axis and therefore may be relative to an orientation of a device. Hence, a first material "over" a second material in the context of a figure provided herein may also be "under" the second material if the device is oriented upside-down relative to the context of the figure provided. In the context of materials, one material disposed over or under another may be directly in contact or may have one or more intervening materials. Moreover, one material disposed between two materials may be directly in contact with the two layers or may have one or more intervening layers. In contrast, a first material "on" a second material is in direct contact with that second material. Similar distinctions are to be made in the context of component assemblies.

The term "between" may be employed in the context of the z-axis, x-axis or y-axis of a device. A material that is between two other materials may be in contact with one or both of those materials, or it may be separated from both of the other two materials by one or more intervening materials. A material "between" two other materials may therefore be in contact with either of the other two materials, or it may be coupled to the other two materials through an intervening material. A device that is between two other devices may be directly connected to one or both of those devices, or it may be separated from both of the other two devices by one or more intervening devices.

Here, multiple non-silicon semiconductor material layers may be stacked within a single fin structure. The multiple non-silicon semiconductor material layers may include one or more "P-type" layers that are suitable (e.g., offer higher hole mobility than silicon) for P-type transistors. The multiple non-silicon semiconductor material layers may further include one or more "N-type" layers that are suitable (e.g., offer higher electron mobility than silicon) for N-type transistors. The multiple non-silicon semiconductor material layers may further include one or more intervening layers separating the N-type from the P-type layers. The intervening layers may be at least partially sacrificial, for example to allow one or more of a gate, source, or drain to wrap completely around a channel region of one or more of the N-type and P-type transistors. The multiple non-silicon semiconductor material layers may be fabricated, at least in part, with self-aligned techniques such that a stacked CMOS device may include both a high-mobility N-type and P-type transistor with a footprint of a single finFET.

Here, the term "backend" generally refers to a section of a die which is opposite of a "frontend" and where an IC (integrated circuit) package couples to IC die bumps. For example, high-level metal layers (e.g., metal layer 6 and above in a ten-metal stack die) and corresponding vias that are closer to a die package are considered part of the backend of the die. Conversely, the term "frontend" generally refers to a section of the die that includes the active region (e.g., where transistors are fabricated) and low-level metal layers and corresponding vias that are closer to the active region (e.g., metal layer 5 and below in the ten-metal stack die example).

It is pointed out that those elements of the figures having the same reference numbers (or names) as the elements of any other figure can operate or function in any manner similar to that described, but are not limited to such.

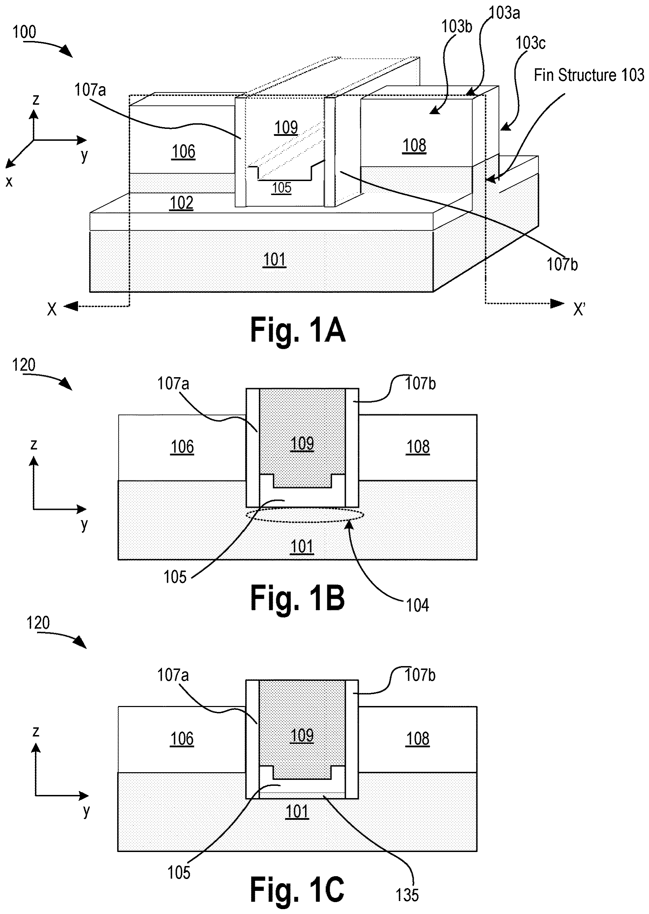

**Figs. 1A-C** illustrate integrated circuit (IC) devices with recessed gate oxide, in accordance with some embodiments. IC device 100 is one example of an embodiment wherein structures of a transistor, diode, or other such device are variously disposed in or on a fin structure. Although structures of IC device 100 are variously shown as having respective rectilinear geometries, in various embodiments some or all such structures - including structures of the non-planar geometries - instead have curved, obliquely angled, tapered, and/or otherwise non-rectilinear shapes. **Fig. 1A** illustrates a three-dimensional (3D) image of a fin field effect transistor (FinFET) 100, **Fig. 1B** illustrates a cross-section 120 of FinFET 100, and **Fig. 1C** illustrates cross-section 120 of FinFET 100 with multilayer gate dielectric.

A FinFET is one type of non-planar transistor which is built around a thin strip of semiconductor material (referred to as the "fin"). The transistor includes the standard field effect transistor (FET) nodes/components: a gate, a gate dielectric, a source region, and a drain region. During operation, a conductive channel of the device resides on the outer sides of the fin beneath the gate dielectric. Specifically, current runs along "sidewalls" of the fin as well as along the top side of the fin. Because the conductive channel essentially resides along the three different outer, planar regions of the fin, such a FinFET is typically referred to as a "tri-gate" FinFET. Other types of FinFETs exist (such as "double-gate" FinFETs in which the conductive channel principally resides only along both sidewalls of the fin and not along the top side of the fin). As gate dimensions get smaller for advanced process technology nodes (e.g., 7 nm and below), having thick gate oxide devices becomes a challenge because the thick gate oxides along the side-walls of the spacers take up enough space that little space is left for depositing metal electrode over the gate oxide. Thin metal oxide results in higher gate resistance.

FinFET 100 comprises a substrate 101, a trench dielectric 102 on substrate 101, and a fin structure 103 disposed in a trench which is formed by trench dielectric 102. Fin structure 103 comprises, for example, a top surface 103a and a pair of laterally opposite sidewalls (sidewall 103b and opposing sidewall 103c, respectively). In some embodiments, portions of fin structure 103 which are vertically offset from one another comprise different respective III-V (and/or other) semiconductor materials.

In some embodiments, substrate comprises of any of a variety of materials that are suitable for use as a substrate of a semiconductor device, and in particular as a substrate for non-planar transistors such as FinFETS and multi-gate transistors. Non-limiting examples of such suitable materials include silicon (Si), germanium (Ge), silicon-germanium (SiGe), silicon-carbide (SiC), sapphire, a III-V semiconductor, a silicon on insulate (SOI) substrate, combinations thereof, and the like. Without limitation, in some embodiments substrate 101 is formed from or includes single crystal silicon.

In some embodiments, one or more underlayers (not illustrated) are deposited on substrate 101, e.g., such that they are present between substrate 101 and one or more of trench dielectric 102 and the materials forming fin structure 103. For example, one or more semiconductor base layers are deposited on substrate 101, in some embodiments. When used, such base layers may be pseudomorphic, metamorphic, or substantially lattice matched buffer and/or transition layers, as understood in the art. In any case, substrate 101 is thus able to provide an epitaxial seeding surface (e.g., a crystalline surface having a (100) or other suitable orientation) for the subsequent deposition of the materials of fin structure 103.

In the embodiment of IC device 100, a trench (not separately labeled) is defined by the sidewalls of trench dielectric 102 (hereinafter, trench sidewalls) and an upper portion of substrate 101. A trench of any of a variety of suitable dimensions may be used, in different embodiments, according to implementation-specific details. Without limitation, in some embodiments, the height (z-axis dimension) and width (y-axis dimension) of the trench enables the deposition of the materials used to form fin structure 110 - e.g., via an aspect ratio trapping (ART) process. Accordingly, in some embodiments the width of the trench is in a range of 1 nanometers (nm) to 500 nanometers (nm), such as in a range of 1 nm to 300 nm, in a range of 1 nm to 100 nm, in a range of 5 nm to 100 nm, or even in a range of 5 nm to 30 nm. Likewise, the height of such a trench is range, for example, in a range of 1 nm to 500 nm, such as a range of 100 nm to 300 nm.

Trench dielectric 102 is formed from any of a variety of materials that are suitable for use as a trench dielectric material of a non-planar semiconductor device. Non-limiting examples of such materials include oxides, nitrides and alloys, such as but not limited to silicon oxide (SiO₂), silicon nitride (SiN), silicon oxycarbide (SiCO), silicon carbon oxynitride (SiCON), silicon carbonitride (SiCN), combinations thereof, and the like. Without limitation, in some embodiments trench dielectric 102 is SiO₂. In more general terms, in some embodiments the non-planar semiconductor device includes a substrate and at least one trench that is formed on or within the substrate. Such a trench is defined by at least two opposing sides (trench sidewalls) and a bottom. A bottom of the trench is formed at least in part by an upper surface of the substrate, and/or one or more buffer and/or transition layers deposited on the substrate.

A non-planar transistor of IC device 100 comprises structures which are variously disposed in or on fin structure 103. For example, such a non-planar transistor may include a channel structure 104 and two source or drain ("SD") structures 106, 108 at opposite ends thereof - e.g., wherein fin structure 103 includes each of doped SD structures 106, 108 and channel structure 104.

In some embodiments, IC device 100 comprises a gate stack formed of at least two layers, gate dielectric layer 105 and gate electrode layer 109. Gate dielectric layer 105 may include one layer or a stack of layers. The one or more layers may include silicon oxide, silicon dioxide (SiO₂) and/or a high-k dielectric material. For example, cross-section 120 illustrates an additional layer 135 (e.g., SiO2) in addition to the high-K dielectric material 105. The high-k dielectric material 105 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, hafnium zirconium oxide, and lead zinc niobate. The high-k materials, can be combined in any form. For example, hafnium oxide and hafnium silicon oxide can be combined. In some embodiments, an annealing process may be carried out on the gate dielectric layer 105 to improve its quality when a high-k material is used.

In some embodiments, gate dielectric 105 comprises ferroelectric material such as hafnium or zirconium-based oxide (Hf or Zr -based oxide). The thickness of FE material along the z-axis is in a rage of 2 nm to 20 nm. The ferroelectric material includes materials such as: hafnium zirconium oxide (HfZrO, also referred to as HZO, which includes hafnium, zirconium, and oxygen), silicon-doped (Si-doped) hafnium oxide (which is a material that includes hafnium, oxygen, and silicon), germanium-doped (Ge-doped) hafnium oxide (which is a material that includes hafnium, oxygen, and germanium), aluminum-doped (Al-doped) hafnium oxide (which is a material that includes hafnium, oxygen, and aluminum), yttrium-doped (Y- doped) hafnium oxide (which is a material that includes hafnium, oxygen, and yttrium), lead zirconate titanate (which is a material that includes lead, zirconium, and titanium), barium zirconate titanate (which is a material that includes barium, zirconium and titanium), and combinations thereof. Some embodiments include hafnium, zirconium, barium, titanium, and/or lead, and combinations thereof for FE material.

Gate electrode layer 109 is formed on gate dielectric layer 105 and may comprise of at least one P-type work-function metal or N-type work-function metal, depending on whether the transistor is to be a PMOS or an NMOS transistor. In some embodiments, the gate electrode layer 109 may comprise of a stack of two or more metal layers, where one or more metal layers are work-function metal layers and at least one metal layer is a conductive fill layer.

For a PMOS transistor, metals that may be used for gate electrode layer 109 include, but are not limited to, ruthenium, palladium, platinum, cobalt, nickel, and conductive metal oxides, e.g., ruthenium oxide. A P-type metal layer will enable the formation of a PMOS gate electrode layer 109 with a work-function that is between about 4.9 eV and about 5.2 eV. For an NMOS transistor, metals that may be used for gate electrode layer 109 include, but are not limited to, hafnium, zirconium, titanium, tantalum, aluminum, alloys of these metals, and carbides of these metals such as hafnium carbide, zirconium carbide, titanium carbide, tantalum carbide, and aluminum carbide. An N-type metal layer will enable the formation of NMOS gate electrode layer 109 with a work-function that is between about 3.9 eV and about 4.2 eV.

In some embodiments, gate electrode layer 109 may comprise a "U"-shaped structure that includes a bottom portion substantially parallel to the surface of the substrate and two sidewall portions that are substantially perpendicular to the top surface of the substrate. In another embodiment, at least one of the metal layers that form gate electrode layer 109 may simply be a planar layer that is substantially parallel to the top surface of the substrate and does not include sidewall portions substantially perpendicular to the top surface of the substrate. In some embodiments, gate electrode layer 109 may comprise of a combination of U-shaped structures and planar, non-U-shaped structures. For example, gate electrode layer 109 may comprise of one or more U-shaped metal layers formed atop one or more planar, non-U-shaped layers.

In some embodiments, a pair of gate dielectric layer (not shown) may be formed on opposing sides of the gate stack that bracket the gate stack. The gate dielectric layer may be formed from a material such as silicon nitride, silicon oxide, silicon carbide, silicon nitride doped with carbon, and silicon oxynitride.

Processes for forming sidewall spacers are well known in the art and generally include deposition and etching process operations. In some embodiments, a plurality of spacer 107a/b pairs may be used; for instance, two pairs, three pairs, or four pairs of sidewall spacers may be formed on opposing sides of the gate stack. In some embodiments, spacers 107a/b include one of: Al2O3, TiO2, HfO2, SiNx, SiCO, SiCN, or SiO2

In some embodiments, source region 106 and drain region 108 are formed within substrate 101 adjacent to the gate stack. Source region 106 and drain region 108 are generally formed using either an implantation/diffusion process or an etching/deposition process. In the former process, dopants such as boron, aluminum, antimony, phosphorous, or arsenic may be ion-implanted into the substrate to form the source region 106 and drain region 108. An annealing process that activates the dopants and causes them to diffuse further into the substrate typically follows the ion implantation process. In the latter process, the substrate may first be etched to form recesses at the locations of the source and drain regions. An epitaxial deposition process may then be carried out to fill the recesses with material that is used to fabricate source region 106 and drain region 108. In some embodiments, the source region 106 and drain region 108 may be fabricated using a silicon alloy such as silicon germanium or silicon carbide. In some embodiments, the epitaxially-deposited silicon alloy may be doped in-situ with dopants such as boron, arsenic, or phosphorous. In some embodiments, source region 106 and drain region 108 may be formed using one or more alternate semiconductor materials such as germanium or a suitable group III-V compound. In some embodiments, one or more layers of metal and/or metal alloys may be used to form source region 106 and drain region 108.

In various embodiments, gate dielectric 105 is recessed such that it no longer extends along the entire height (along the z-direction) of spacers 107a and 107b. For example, most (e.g., at least 80% or more) of the gate dielectric along the vertical direction (e.g., z-direction) of spacers 107a and 107b is removed. This is in contrast to traditional gate dielectric which has a complete U-shape having sections over channel 104, and sections along the entire height of spacers 107a/b. Such embodiment allows IC device 100 to have thicker gate electric 105 over channel region 104 while allowing for low resistance metal gate electrode 107 because the area for gate dielectric abutting spacers is mostly vacated.

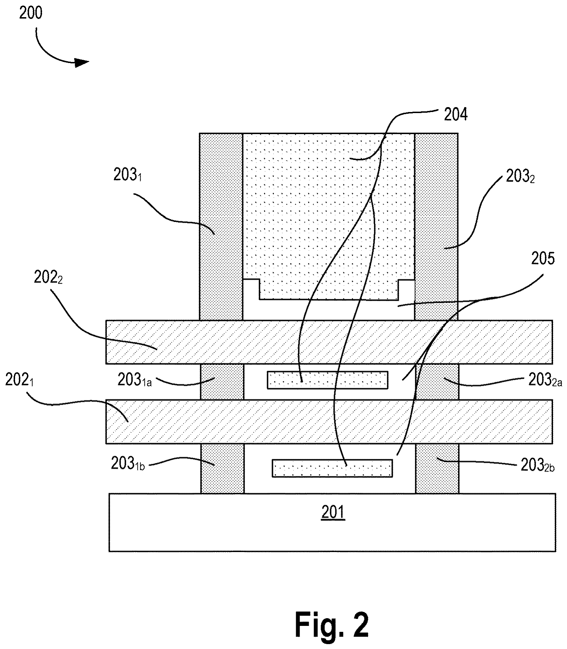

**Fig. 2** illustrates a cross-section of a nanowire transistor with recessed gate oxide, in accordance with some embodiments. The cross-sectional view is a simplified figure that shows a stack of two nanowires with all-around gate formed on a substrate. In this example, nanowire device 200 comprises substrate 201, nanowires 202₁₋₂, spacers 203₁₋₂, and gate 204.

In some embodiments, substrate 201 includes a silicon support substrate, upon which a buffer layer is epitaxially grown. In some embodiments, the support substrate may also be of alternate materials, which may or may not be combined with silicon, including, but not limited to, germanium, indium antimonide, lead telluride, indium arsenide, indium phosphide, gallium nitride, gallium arsenide, or gallium antimonide, carbon (SiC), and sapphire. In some embodiments, substrate 201 includes a dielectric layer such as a buried oxide (BoX) which may be formed by transferring one or more layers of the semiconductor from which the nanowires are formed onto the substrate 201.

In some embodiments, nanowires 202₁₋₂ are crystalline with much greater long-range order than a polycrystalline material. In some embodiments, channel regions formed by the nanowires are substantially a single crystalline. A person skilled in the art would appreciate that while single crystalline nanowires may be referred to as monocrystalline, a low level of crystal defects may nevertheless be present as artifacts of an imperfect epitaxial growth process.

In some embodiments, nanowires 202₁₋₂ include one or more of: Si, Ge, Ga, As, In, N, or P. In some embodiments, nanowires 202₁₋₂ are n-type nanowires or p-type nanowires. In some embodiments, when nanowires 202₁₋₂ are p-type nanowires they comprise germanium (Ge). Germanium has high hole mobility and lattice parameters that are sufficiently matched to some group III-V semiconductor materials for good quality epitaxial stacks of Ge layers and group III-V semiconductor layers. In some embodiments, p-type nanowire 202₁₋₂ are composed of a group IV alloy (e.g., SiGe) or composed of silicon.

In some embodiments, when nanowires 202₁₋₂ are n-type nanowires they are comprised of a group III-V semiconductor material. In some embodiments, when a p-type nanowire comprises of germanium, the n-type nanowire comprises of GaAs. In some embodiments, the n-type nanowires 202₁₋₂ include one or more of: InAs, a group III-N (e.g., GaN), InP, a ternary alloy comprising GaAs, a ternary alloy comprising InAs, a ternary alloy comprising InP, or a ternary alloy comprising a group III-N, or a quaternary alloy comprising GaAs, a quaternary alloy comprising InAs, a quaternary alloy comprising InP, or a quaternary alloy comprising a group III-N. In some embodiments, the channel regions in both the p-type nanowire and n-type nanowires are substantially undoped for highest carrier mobility. For simplicity, two nanowires are shown in a stack. However, in some embodiments, more than two nanowires can be fabricated in a stack, and in some embodiments, multiple stacks can be formed in parallel for the same nanowire device (or transistor).

For simplicity, source and drain regions are not shown. However, a person skilled in the art would appreciate that source and drain regions are formed on either side of spacers 203₁₋₂. In some embodiments, the source regions (not shown) comprise the same semiconductor material present in the channel region for the respective p-type and n-type nanowires, but the source and drain regions further include a higher concentration of dopant. In some embodiments, the p-type nanowire source/drain region comprises a high p-type impurity (e.g., P+ dopant) while the n-type nanowire source/drain region comprises a high n-type impurity (e.g., N+ dopant). In some embodiments, the source and drain regions maintain the same mono-crystallinity as within the channel region of the nanowires 202₁₋₂. In some embodiments, at least one of the source/drains are contacted with an ohmic metal (not shown) that coaxially wraps completely around the nanowires 202₁₋₂ to fill in the gaps between the nanowires and the substrate 201. The source/drain contacts may further include an epitaxially grown semiconductor of different composition than the nanowires 202₁₋₂. For example, a tunnel junction (e.g., a p+ layer wrapping around the source region of the nanowire) may provide an ultra-steep turn on and off (e.g., improved sub-threshold performance). As another example, in-situ doped semiconductor may be grown completely around the released source/drains for lower contact resistance.

In some embodiments, spacers 203₁₋₂ are low-K dielectrics. Low-K dielectrics are materials with dielectric constants that are smaller than dielectric constants of Silicon Dioxide (SiO₂). In some embodiments, material for spacers 203₁₋₂ include one or more of fluorine-doped silicon dioxide, carbon-doped silicon dioxide, porous silicon dioxide, porous carbon-doped silicon dioxide, spin-on organic polymeric dielectrics (e.g., polyimide, polynorbornenes, benzocyclobutene, PTFE, etc.), or spin-on silicon polymeric dielectrics (e.g., hydrogen silsesquioxane, methylsilsesquioxane, etc.).

In some embodiments, gate 204 comprises one or more of: Gd, O, Hf, Si, Ta, Al, Ti, W, Zr, La, N, or a combination of them. In various embodiments, gate 204 comprises gate conductors and dielectrics that wrap around nanowires 202₁₋₂. In some embodiments, gate conductors are electrically isolated from nanowires 202₁₋₂ by a gate dielectric material. In some embodiments, the gate dielectric material may include one or more of any material known in the art to be suitable for FET gate dielectrics (and/or channel passivation) and is preferably a high-K dielectric (e.g., having a dielectric constant greater than that of silicon nitride (Si₃N₄)), such as, but not limited to, high-K oxides such as gadolinium oxide (Gd₂O₃), hafnium oxide (HfO₂), high-K silicates such as HfSiO, TaSiO, AlSiO, and high-K nitrides such as HfON.

In some embodiments, the gate conductor may be of any material known in the art for gate electrodes suitable for the particular nanowire semiconductor composition and desired threshold voltage and operative mode (e.g., enhancement or depletion). In some embodiments, the same gate dielectric material is employed for the p-type gate dielectric and the n-type gate dielectric. In some embodiments, the gate conductor composition includes a work function metal which may be selected to be distinct for each of the p-type gate conductor and the n-type gate conductor to obtain a desired threshold voltage (Vt) (e.g., greater than 0 V, etc.). In some embodiments, the conductive gate materials include one or more of: tungsten (W), aluminum (Al), titanium (Ti), tantalum(Ta), nickel (Ni), molybdenum (Mo), germanium (Ge), platinum (Pt), gold (Au), ruthenium (Ru), palladium (Pd), iridium (Ir), their alloys and silicides, carbides, nitrides, phosphides, and carbonitrides thereof.

Gate 204 includes gate dielectric 205 and gate electrode 204. In various embodiments, gate dielectric 205 is recessed such that it no longer extends along the entire height (along the z-direction) of spacers 203₁ and 203₂. This is in contrast to traditional gate dielectric which has a complete U-shape having sections over the channel, and sections along the entire height of spacers 203₁₋₂. Such an embodiment allows IC device 200 to have thicker gate electric 205 over channel region while allowing for low resistance metal gate electrode 204 because the area for gate dielectric abutting spacers is mostly vacated.

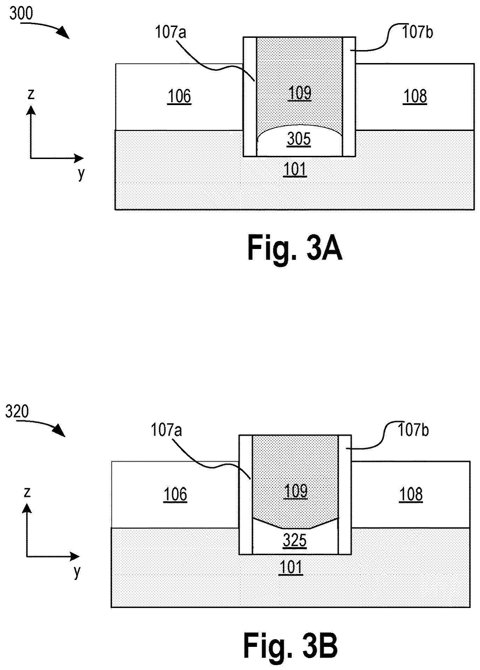

**Figs. 3A-B** illustrate various forms 300 and 320 of recessed gate oxide, respectively, in accordance with some embodiments. Transistor views 120 and 220 illustrate recessed gate dielectric in U-shape. View 300 illustrates a convex recessed gate dielectric 305. View 320 illustrates a concave recessed gate dielectric 325. In some embodiments, recessed gate dielectric 305 has a flat surface (not shown) extending from spacer 107a to spacer 107b.

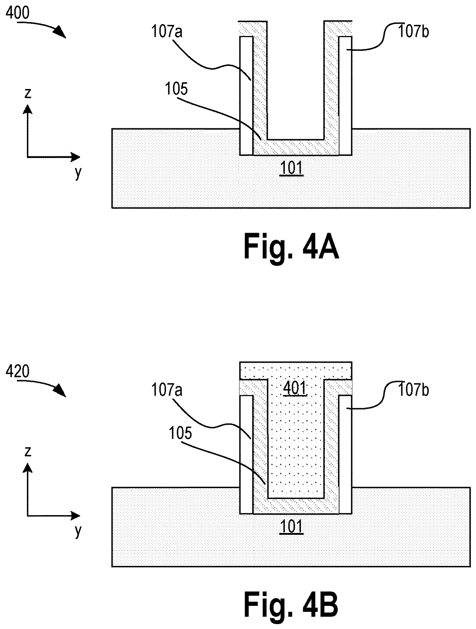

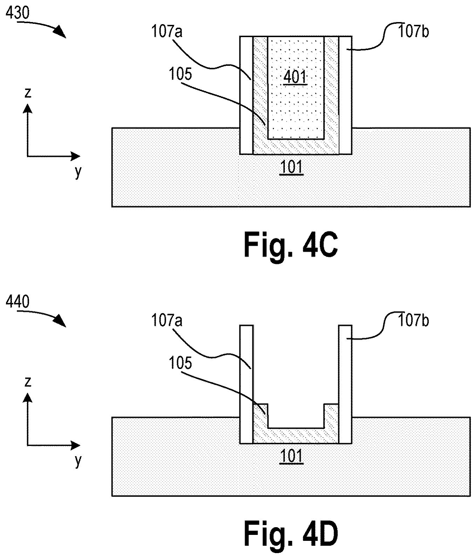

**Figs. 4A-D** illustrate cross-sections 400, 420, 430, and 440, respectively, of a process of forming recessed gate oxide, in accordance with some embodiments. So as not to obscure the process, here gate formation is shown while other aspects of transistor fabrication are not shown. Cross-section 400 shows conformal deposition of gate dielectric 105 after spacers 107a/b are fabricated. Here, gate dielectric 105 deposits along the side walls of spacers 107a/b and substrate 101. Gate dielectric 105 can be one layer or multiple layers. Cross-section 420 illustrates conformal deposition of sacrificial material 401. Examples of sacrificial material 401 include carbon-based hard mask or metal mask such as Co, Ti, TiN, TiCN, and so on. Cross-section 430 illustrates etching and then polishing sacrificial material 401 and gate dielectric on the top surface of the gate. Cross-section 440 illustrates etching and removal of the polishing sacrificial material 401. This process leaves behind a recessed gate dielectric 105.

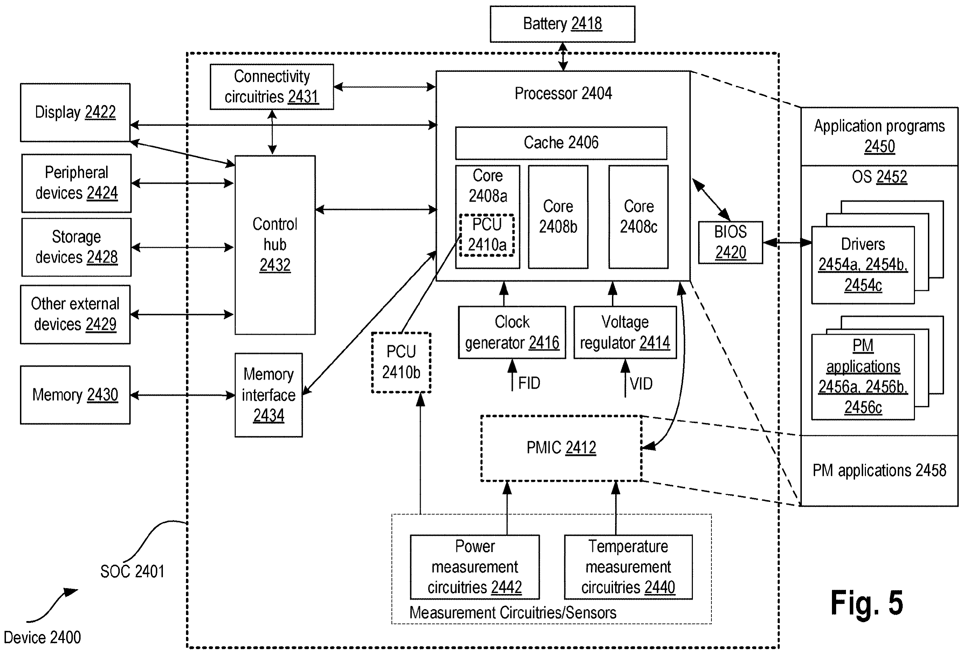

**Fig. 5** illustrates a smart device, a computer system, or a SoC (System-on-Chip) including a transistor with recessed gate oxide, in accordance with some embodiments of the disclosure. In some embodiments, device 2400 represents an appropriate computing device, such as a computing tablet, a mobile phone or smart-phone, a laptop, a desktop, an Internet-of-Things (IOT) device, a server, a wearable device, a set-top box, a wireless-enabled e-reader, or the like. It will be understood that certain components are shown generally, and not all components of such a device are shown in device 2400. Any of the components shown here can have one or more transistors with recessed gate oxide.

In an example, the device 2400 comprises a SoC (System-on-Chip) 2401. An example boundary of the SOC 2401 is illustrated using dotted lines in **Fig. 5****,** with some example components being illustrated to be included within SOC 2401 - however, SOC 2401 may include any appropriate components of device 2400.

In some embodiments, device 2400 includes processor 2404. Processor 2404 can include one or more physical devices, such as microprocessors, application processors, microcontrollers, programmable logic devices, processing cores, or other processing means. The processing operations performed by processor 2404 include the execution of an operating platform or operating system on which applications and/or device functions are executed. The processing operations include operations related to I/O (input/output) with a human user or with other devices, operations related to power management, operations related to connecting computing device 2400 to another device, and/or the like. The processing operations may also include operations related to audio I/O and/or display I/O.

In some embodiments, processor 2404 includes multiple processing cores (also referred to as cores) 2408a, 2408b, 2408c. Although merely three cores 2408a, 2408b, and 2408c, are illustrated in **Fig. 5****,** the processor 2404 may include any other appropriate number of processing cores, e.g., tens, or even hundreds of processing cores. Processor cores 2408a, 2408b, 2408c may be implemented on a single integrated circuit (IC) chip. Moreover, the chip may include one or more shared and/or private caches, buses or interconnections, graphics and/or memory controllers, or other components.

In some embodiments, processor 2404 includes cache 2406. In an example, sections of cache 2406 may be dedicated to individual cores 2408 (e.g., a first section of cache 2406 dedicated to core 2408a, a second section of cache 2406 dedicated to core 2408b, and so on). In an example, one or more sections of cache 2406 may be shared among two or more of cores 2408. Cache 2406 may be split in different levels, e.g., level 1 (L1) cache, level 2 (L2) cache, level 3 (L3) cache, etc.

In some embodiments, processor core 2404 may include a fetch unit to fetch instructions (including instructions with conditional branches) for execution by the core 2404. The instructions may be fetched from any storage devices such as the memory 2430. Processor core 2404 may also include a decode unit to decode the fetched instruction. For example, the decode unit may decode the fetched instruction into a plurality of micro-operations. Processor core 2404 may include a schedule unit to perform various operations associated with storing decoded instructions. For example, the schedule unit may hold data from the decode unit until the instructions are ready for dispatch, e.g., until all source values of a decoded instruction become available. In one embodiment, the schedule unit may schedule and/or issue (or dispatch) decoded instructions to an execution unit for execution.

The execution unit may execute the dispatched instructions after they are decoded (e.g., by the decode unit) and dispatched (e.g., by the schedule unit). In an embodiment, the execution unit may include more than one execution unit (such as an imaging computational unit, a graphics computational unit, a general-purpose computational unit, etc.). The execution unit may also perform various arithmetic operations, such as, addition, subtraction, multiplication, and/or division. The execution unit may include one or more an arithmetic logic units (ALUs). In an embodiment, a co-processor (not shown) may perform various arithmetic operations in conjunction with the execution unit.

Further, execution unit may execute instructions out-of-order. Hence, processor core 2404 may be an out-of-order processor core in one embodiment. Processor core 2404 may also include a retirement unit. The retirement unit may retire executed instructions after they are committed. In an embodiment, retirement of the executed instructions may result in processor state being committed from the execution of the instructions, physical registers used by the instructions being deallocated, etc. The processor core 2404 may also include a bus unit to enable communication between components of the processor core 2404 and other components via one or more buses. Processor core 2404 may also include one or more registers to store data accessed by various components of the core 2404 (such as values related to assigned app priorities and/or sub-system states (modes) association.

In some embodiments, device 2400 comprises connectivity circuitries 2431. For example, connectivity circuitries 2431 includes hardware devices (e.g., wireless and/or wired connectors and communication hardware) and/or software components (e.g., drivers, protocol stacks), e.g., to enable device 2400 to communicate with external devices. Device 2400 may be separate from the external devices, such as other computing devices, wireless access points or base stations, etc.

In an example, connectivity circuitries 2431 may include multiple different types of connectivity. To generalize, the connectivity circuitries 2431 may include cellular connectivity circuitries, wireless connectivity circuitries, etc. Cellular connectivity circuitries of connectivity circuitries 2431 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, 3rd Generation Partnership Project (3GPP) Universal Mobile Telecommunications Systems (UMTS) system or variations or derivatives, 3GPP Long-Term Evolution (LTE) system or variations or derivatives, 3GPP LTE-Advanced (LTE-A) system or variations or derivatives, Fifth Generation (5G) wireless system or variations or derivatives, 5G mobile networks system or variations or derivatives, 5G New Radio (NR) system or variations or derivatives, or other cellular service standards. Wireless connectivity circuitries (or wireless interface) of the connectivity circuitries 2431 refers to wireless connectivity that is not cellular, and can include personal area networks (such as Bluetooth, Near Field, etc.), local area networks (such as Wi-Fi), and/or wide area networks (such as WiMax), and/or other wireless communication. In an example, connectivity circuitries 2431 may include a network interface, such as a wired or wireless interface, e.g., so that a system embodiment may be incorporated into a wireless device, for example, cell phone or personal digital assistant.

In some embodiments, device 2400 comprises control hub 2432, which represents hardware devices and/or software components related to interaction with one or more I/O devices. For example, processor 2404 may communicate with one or more of display 2422, one or more peripheral devices 2424, storage devices 2428, one or more other external devices 2429, etc., via control hub 2432. Control hub 2432 may be a chipset, a Platform Control Hub (PCH), and/or the like.

For example, control hub 2432 illustrates one or more connection points for additional devices that connect to device 2400, e.g., through which a user might interact with the system. For example, devices (e.g., devices 2429) that can be attached to device 2400 include microphone devices, speaker or stereo systems, audio devices, video systems or other display devices, keyboard or keypad devices, or other I/O devices for use with specific applications such as card readers or other devices.

As mentioned above, control hub 2432 can interact with audio devices, display 2422, etc. For example, input through a microphone or other audio device can provide input or commands for one or more applications or functions of device 2400. Additionally, audio output can be provided instead of, or in addition to display output. In another example, if display 2422 includes a touch screen, display 2422 also acts as an input device, which can be at least partially managed by control hub 2432. There can also be additional buttons or switches on computing device 2400 to provide I/O functions managed by control hub 2432. In one embodiment, control hub 2432 manages devices such as accelerometers, cameras, light sensors or other environmental sensors, or other hardware that can be included in device 2400. The input can be part of direct user interaction, as well as providing environmental input to the system to influence its operations (such as filtering for noise, adjusting displays for brightness detection, applying a flash for a camera, or other features).

In some embodiments, control hub 2432 may couple to various devices using any appropriate communication protocol, e.g., PCIe (Peripheral Component Interconnect Express), USB (Universal Serial Bus), Thunderbolt, High Definition Multimedia Interface (HDMI), Firewire, etc.

In some embodiments, display 2422 represents hardware (e.g., display devices) and software (e.g., drivers) components that provide a visual and/or tactile display for a user to interact with device 2400. Display 2422 may include a display interface, a display screen, and/or hardware device used to provide a display to a user. In some embodiments, display 2422 includes a touch screen (or touch pad) device that provides both output and input to a user. In an example, display 2422 may communicate directly with the processor 2404. Display 2422 can be one or more of an internal display device, as in a mobile electronic device or a laptop device or an external display device attached via a display interface (e.g., DisplayPort, etc.). In one embodiment display 2422 can be a head mounted display (HMD) such as a stereoscopic display device for use in virtual reality (VR) applications or augmented reality (AR) applications.

In some embodiments and although not illustrated in the figure, in addition to (or instead of) processor 2404, device 2400 may include Graphics Processing Unit (GPU) comprising one or more graphics processing cores, which may control one or more aspects of displaying contents on display 2422.

Control hub 2432 (or platform controller hub) may include hardware interfaces and connectors, as well as software components (e.g., drivers, protocol stacks) to make peripheral connections, e.g., to peripheral devices 2424.

It will be understood that device 2400 could both be a peripheral device to other computing devices, as well as have peripheral devices connected to it. Device 2400 may have a "docking" connector to connect to other computing devices for purposes such as managing (e.g., downloading and/or uploading, changing, synchronizing) content on device 2400. Additionally, a docking connector can allow device 2400 to connect to certain peripherals that allow computing device 2400 to control content output, for example, to audiovisual or other systems.

In addition to a proprietary docking connector or other proprietary connection hardware, device 2400 can make peripheral connections via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

In some embodiments, connectivity circuitries 2431 may be coupled to control hub 2432, e.g., in addition to, or instead of, being coupled directly to the processor 2404. In some embodiments, display 2422 may be coupled to control hub 2432, e.g., in addition to, or instead of, being coupled directly to processor 2404.

In some embodiments, device 2400 comprises memory 2430 coupled to processor 2404 via memory interface 2434. Memory 2430 includes memory devices for storing information in device 2400. Memory can include nonvolatile (state does not change if power to the memory device is interrupted) and/or volatile (state is indeterminate if power to the memory device is interrupted) memory devices. Memory device 2430 can be a dynamic random access memory (DRAM) device, a static random access memory (SRAM) device, flash memory device, phase-change memory device, or some other memory device having suitable performance to serve as process memory. In one embodiment, memory 2430 can operate as system memory for device 2400, to store data and instructions for use when the one or more processors 2404 executes an application or process. Memory 2430 can store application data, user data, music, photos, documents, or other data, as well as system data (whether long-term or temporary) related to the execution of the applications and functions of device 2400.

Elements of various embodiments and examples are also provided as a machine-readable medium (e.g., memory 2430) for storing the computer-executable instructions (e.g., instructions to implement any other processes discussed herein). The machine-readable medium (e.g., memory 2430) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

In some embodiments, device 2400 comprises temperature measurement circuitries 2440, e.g., for measuring temperature of various components of device 2400. In an example, temperature measurement circuitries 2440 may be embedded, or coupled or attached to various components, whose temperature are to be measured and monitored. For example, temperature measurement circuitries 2440 may measure temperature of (or within) one or more of cores 2408a, 2408b, 2408c, voltage regulator 2414, memory 2430, a mother-board of SOC 2401, and/or any appropriate component of device 2400.

In some embodiments, device 2400 comprises power measurement circuitries 2442, e.g., for measuring power consumed by one or more components of the device 2400. In an example, in addition to, or instead of, measuring power, the power measurement circuitries 2442 may measure voltage and/or current. In an example, the power measurement circuitries 2442 may be embedded, or coupled or attached to various components, whose power, voltage, and/or current consumption are to be measured and monitored. For example, power measurement circuitries 2442 may measure power, current and/or voltage supplied by one or more voltage regulators 2414, power supplied to SOC 2401, power supplied to device 2400, power consumed by processor 2404 (or any other component) of device 2400, etc.

In some embodiments, device 2400 comprises one or more voltage regulator circuitries, generally referred to as voltage regulator (VR) 2414. VR 2414 generates signals at appropriate voltage levels, which may be supplied to operate any appropriate components of the device 2400. Merely as an example, VR 2414 is illustrated to be supplying signals to processor 2404 of device 2400. In some embodiments, VR 2414 receives one or more Voltage Identification (VID) signals, and generates the voltage signal at an appropriate level, based on the VID signals. Various type of VRs may be utilized for the VR 2414. For example, VR 2414 may include a "buck" VR, "boost" VR, a combination of buck and boost VRs, low dropout (LDO) regulators, switching DC-DC regulators, etc. Buck VR is generally used in power delivery applications in which an input voltage needs to be transformed to an output voltage in a ratio that is smaller than unity. Boost VR is generally used in power delivery applications in which an input voltage needs to be transformed to an output voltage in a ratio that is larger than unity. In some embodiments, each processor core has its own VR which is controlled by PCU 2410a/b and/or PMIC 2412. In some embodiments, each core has a network of distributed LDOs to provide efficient control for power management. The LDOs can be digital, analog, or a combination of digital or analog LDOs.

In some embodiments, device 2400 comprises one or more clock generator circuitries, generally referred to as clock generator 2416. Clock generator 2416 generates clock signals at appropriate frequency levels, which may be supplied to any appropriate components of device 2400. Merely as an example, clock generator 2416 is illustrated to be supplying clock signals to processor 2404 of device 2400. In some embodiments, clock generator 2416 receives one or more Frequency Identification (FID) signals, and generates the clock signals at an appropriate frequency, based on the FID signals.

In some embodiments, device 2400 comprises battery 2418 supplying power to various components of device 2400. Merely as an example, battery 2418 is illustrated to be supplying power to processor 2404. Although not illustrated in the figures, device 2400 may comprise a charging circuitry, e.g., to recharge the battery, based on Alternating Current (AC) power supply received from an AC adapter.

In some embodiments, device 2400 comprises Power Control Unit (PCU) 2410 (also referred to as Power Management Unit (PMU), Power Controller, etc.). In an example, some sections of PCU 2410 may be implemented by one or more processing cores 2408, and these sections of PCU 2410 are symbolically illustrated using a dotted box and labelled PCU 2410a. In an example, some other sections of PCU 2410 may be implemented outside the processing cores 2408, and these sections of PCU 2410 are symbolically illustrated using a dotted box and labelled as PCU 2410b. PCU 2410 may implement various power management operations for device 2400. PCU 2410 may include hardware interfaces, hardware circuitries, connectors, registers, etc., as well as software components (e.g., drivers, protocol stacks), to implement various power management operations for device 2400.

In some embodiments, device 2400 comprises Power Management Integrated Circuit (PMIC) 2412, e.g., to implement various power management operations for device 2400. In some embodiments, PMIC 2412 is a Reconfigurable Power Management ICs (RPMICs) and/or an IMVP (Intel® Mobile Voltage Positioning). In an example, the PMIC is within an IC chip separate from processor 2404. The may implement various power management operations for device 2400. PMIC 2412 may include hardware interfaces, hardware circuitries, connectors, registers, etc., as well as software components (e.g., drivers, protocol stacks), to implement various power management operations for device 2400.

In an example, device 2400 comprises one or both PCU 2410 or PMIC 2412. In an example, any one of PCU 2410 or PMIC 2412 may be absent in device 2400, and hence, these components are illustrated using dotted lines.

Various power management operations of device 2400 may be performed by PCU 2410, by PMIC 2412, or by a combination of PCU 2410 and PMIC 2412. For example, PCU 2410 and/or PMIC 2412 may select a power state (e.g., P-state) for various components of device 2400. For example, PCU 2410 and/or PMIC 2412 may select a power state (e.g., in accordance with the ACPI (Advanced Configuration and Power Interface) specification) for various components of device 2400. Merely as an example, PCU 2410 and/or PMIC 2412 may cause various components of the device 2400 to transition to a sleep state, to an active state, to an appropriate C state (e.g., C0 state, or another appropriate C state, in accordance with the ACPI specification), etc. In an example, PCU 2410 and/or PMIC 2412 may control a voltage output by VR 2414 and/or a frequency of a clock signal output by the clock generator, e.g., by outputting the VID signal and/or the FID signal, respectively. In an example, PCU 2410 and/or PMIC 2412 may control battery power usage, charging of battery 2418, and features related to power saving operation.

The clock generator 2416 can comprise a phase locked loop (PLL), frequency locked loop (FLL), or any suitable clock source. In some embodiments, each core of processor 2404 has its own clock source. As such, each core can operate at a frequency independent of the frequency of operation of the other core. In some embodiments, PCU 2410 and/or PMIC 2412 performs adaptive or dynamic frequency scaling or adjustment. For example, clock frequency of a processor core can be increased if the core is not operating at its maximum power consumption threshold or limit. In some embodiments, PCU 2410 and/or PMIC 2412 determines the operating condition of each core of a processor, and opportunistically adjusts frequency and/or power supply voltage of that core without the core clocking source (e.g., PLL of that core) losing lock when the PCU 2410 and/or PMIC 2412 determines that the core is operating below a target performance level. For example, if a core is drawing current from a power supply rail less than a total current allocated for that core or processor 2404, then PCU 2410 and/or PMIC 2412 can temporality increase the power draw for that core or processor 2404 (e.g., by increasing clock frequency and/or power supply voltage level) so that the core or processor 2404 can perform at higher performance level. As such, voltage and/or frequency can be increased temporality for processor 2404 without violating product reliability.

In an example, PCU 2410 and/or PMIC 2412 may perform power management operations, e.g., based at least in part on receiving measurements from power measurement circuitries 2442, temperature measurement circuitries 2440, charge level of battery 2418, and/or any other appropriate information that may be used for power management. To that end, PMIC 2412 is communicatively coupled to one or more sensors to sense/detect various values/variations in one or more factors having an effect on power/thermal behavior of the system/platform. Examples of the one or more factors include electrical current, voltage droop, temperature, operating frequency, operating voltage, power consumption, inter-core communication activity, etc. One or more of these sensors may be provided in physical proximity (and/or thermal contact/coupling) with one or more components or logic/IP blocks of a computing system. Additionally, sensor(s) may be directly coupled to PCU 2410 and/or PMIC 2412 in at least one embodiment to allow PCU 2410 and/or PMIC 2412 to manage processor core energy at least in part based on value(s) detected by one or more of the sensors.

Also illustrated is an example software stack of device 2400 (although not all elements of the software stack are illustrated). Merely as an example, processors 2404 may execute application programs 2450, Operating System 2452, one or more Power Management (PM) specific application programs (e.g., generically referred to as PM applications 2458), and/or the like. PM applications 2458 may also be executed by the PCU 2410 and/or PMIC 2412. OS 2452 may also include one or more PM applications 2456a, 2456b, 2456c. The OS 2452 may also include various drivers 2454a, 2454b, 2454c, etc., some of which may be specific for power management purposes. In some embodiments, device 2400 may further comprise a Basic Input/Output System (BIOS) 2420. BIOS 2420 may communicate with OS 2452 (e.g., via one or more drivers 2454), communicate with processors 2404, etc.

For example, one or more of PM applications 2458, 2456, drivers 2454, BIOS 2420, etc. may be used to implement power management specific tasks, e.g., to control voltage and/or frequency of various components of device 2400, to control wake-up state, sleep state, and/or any other appropriate power state of various components of device 2400, control battery power usage, charging of the battery 2418, features related to power saving operation, etc.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional element.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

Following examples illustrates various embodiments. The examples can be combined in any suitable manner.

Example 1: An apparatus comprising: a source region; a drain region; and a gate region between the source and drain regions, wherein the gate region comprises: high-K dielectric material between spacers such that the high-K dielectric material is recessed; and metal electrode on the recessed high-K dielectric material.

Example 2: The apparatus of example 1, wherein the high-K dielectric material includes one of: hafnium, silicon, oxygen, titanium, tantalum, lanthanum, aluminum, zirconium, barium, strontium, yttrium, lead, scandium, niobium, or zinc.

Example 3: The apparatus of example 1, wherein the high-K dielectric material is first dielectric material, and wherein the high-K dielectric material is on a second dielectric material different from the high-K dielectric material.

Example 4: The apparatus of example 3, wherein the second dielectric material comprises Si.

Example 5: The apparatus of example 3, wherein the first or second dielectric materials comprise ferroelectric material.

Example 6: The apparatus of example 1, wherein the recessed high-K dielectric material is U-shaped.

Example 7: The apparatus of example 1, wherein the metal electrode comprises one or more of: ruthenium, palladium, platinum, cobalt, nickel, or conductive metal oxides.

Example 8: The apparatus of example 1, wherein the metal electrode comprises one or more of: hafnium, zirconium, titanium, tantalum, aluminum, alloys of these metals, hafnium carbide, zirconium carbide, titanium carbide, tantalum carbide, or aluminum carbide.

Example 9: The apparatus of example 1, wherein the spacers include one or more of: Al, Ti, Hf, Si, or N.

Example 10: A system comprising: a memory; a processor coupled to the memory, the processor including a transistor which comprises: a source region; a drain region; and a gate region between the source and drain regions, wherein the gate region comprises: high-K dielectric material between spacers such that the high-K dielectric material is recessed; and metal electrode on the recessed high-K dielectric material; and a wireless interface to allow the processor to communicate with another device.

Example 11: The system of example 10, wherein the transistor is one of: double-gate transistor, tri-gate transistors, wrap-around, all-around gate transistor, nanoribbon, or nanowire transistors.

Example 12: The system of example 10, wherein the high-K dielectric material is substantially absent from being along sidewalls of the spacers.

Example 13: The system of example 10, wherein the recessed high-K dielectric material is U-shaped.

Example 14: The system of example 10, wherein the high-K dielectric material includes one of: hafnium, silicon, oxygen, titanium, tantalum, lanthanum, aluminum, zirconium, barium, strontium, yttrium, lead, scandium, niobium, or zinc.

Example 15: The system of example 10, wherein the metal electrode comprises one or more of: hafnium, zirconium, titanium, tantalum, aluminum, alloys of these metals, hafnium carbide, zirconium carbide, titanium carbide, tantalum carbide, or aluminum carbide.

Example 16: The system of example 10, wherein the spacers include one or more of: Al, Ti, Hf, Si, or N.

Example 17: A method comprising: forming spacers on either sides of a first dielectric; conformably depositing a second dielectric between the spacers and over the first electric; depositing a sacrificial material over the second dielectric; removing the sacrificial material and the second dielectric along a plane of a device; etching material between the spaces such that substantially all of second dielectric is removed from sidewalls of the spacers and leaving the second dielectric as recessed; and depositing metal gate over the recessed second dielectric.

Example 18: The method of example 17, wherein conformably depositing the second dielectric comprises depositing one or more of: hafnium, silicon, oxygen, titanium, tantalum, lanthanum, aluminum, zirconium, barium, strontium, yttrium, lead, scandium, niobium, or zinc, and wherein the second dielectric is a High-K dielectric.

Example 19: The method of example 17, wherein depositing the metal gate over the recessed second dielectric comprises depositing one or more of: hafnium, zirconium, titanium, tantalum, aluminum, alloys of these metals, hafnium carbide, zirconium carbide, titanium carbide, tantalum carbide, or aluminum carbide.

Example 20: The method of example 17 comprises forming source and drain regions on either sides of the first dielectric.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus comprising:
a source region;
a drain region; and
a gate region between the source and drain regions, wherein the gate region comprises:
high-K dielectric material between spacers such that the high-K dielectric material is recessed; and
metal electrode on the recessed high-K dielectric material.

2. The apparatus of claim 1, wherein the high-K dielectric material includes one of:
hafnium, silicon, oxygen, titanium, tantalum, lanthanum, aluminum, zirconium, barium, strontium, yttrium, lead, scandium, niobium, or zinc.

3. The apparatus of claim 1, wherein the high-K dielectric material is first dielectric material, and wherein the high-K dielectric material is on a second dielectric material different from the high-K dielectric material.

4. The apparatus of claim 3, wherein the second dielectric material comprises Si.

5. The apparatus of claim 3, wherein the first or second dielectric materials comprise ferroelectric material.

6. The apparatus of claim 1, wherein the recessed high-K dielectric material is U-shaped.

7. The apparatus of claim 1, wherein the metal electrode comprises one or more of:
ruthenium, palladium, platinum, cobalt, nickel, or conductive metal oxides.

8. The apparatus according to any one of claims 1 to 7, wherein the metal electrode comprises one or more of: hafnium, zirconium, titanium, tantalum, aluminum, alloys of these metals, hafnium carbide, zirconium carbide, titanium carbide, tantalum carbide, or aluminum carbide.

9. The apparatus according to any one of claims 1 to 7, wherein the spacers include one or more of: Al, Tu, Hf, Si, or N.

10. A system comprising:
a memory;
a processor coupled to the memory, the processor including a transistor which comprises an apparatus according to any one of claims 1 to 9; and
a wireless interface to allow the processor to communicate with another device.

11. The system of claim 10, wherein the transistor is one of: double-gate transistor, tri-gate transistors, wrap-around, all-around gate transistor, nanoribbon, or nanowire transistors.

12. The system of claim 10, wherein the high-K dielectric material is substantially absent from being along sidewalls of the spacers.

13. A method comprising:
forming spacers on either sides of a first dielectric;
conformably depositing a second dielectric between the spacers and over the first electric;
depositing a sacrificial material over the second dielectric;
removing the sacrificial material and the second dielectric along a plane of a device;
etching material between the spaces such that substantially all of second dielectric is removed from sidewalls of the spacers and leaving the second dielectric as recessed; and
depositing metal gate over the recessed second dielectric; and
forming source and drain regions on either sides of the first dielectric.

14. The method of claim 13, wherein conformably depositing the second dielectric comprises depositing one or more of: hafnium, silicon, oxygen, titanium, tantalum, lanthanum, aluminum, zirconium, barium, strontium, yttrium, lead, scandium, niobium, or zinc, and wherein the second dielectric is a High-K dielectric.

15. The method of claim 13, wherein depositing the metal gate over the recessed second dielectric comprises depositing one or more of: hafnium, zirconium, titanium, tantalum, aluminum, alloys of these metals, hafnium carbide, zirconium carbide, titanium carbide, tantalum carbide, or aluminum carbide.
